# EUROPEAN PATENT APPLICATION

(11) **EP 2 143 833 A1**
(43) Date of publication of application: **13.01.2010**
(21) Application number: 08751878.3
(22) Date of filing: 18.04.2008
(51) Int. Cl.: C30B 29/06, C30B 13/00

(54) **SILICON CRYSTAL MATERIAL AND METHOD FOR MANUFACTURING FZ SILICON SINGLE CRYSTAL BY USING THE SAME**

(30) Priority: 24.04.2007 JP 2007113904
(71) Applicant: Sumco Techxiv Corporation, Omura-shi, Nagasaki 856-8555 (JP)
(72) Inventor: TOGAWA, Shinji, Omura-shi Nagasaki 856-8555 (JP); SHIRAISHI, Yutaka, Omura-shi Nagasaki 856-8555 (JP)
(74) Representative: Cabinet Plasseraud
(86) International application number: PCT/JP2008/057608
(87) International publication number: WO 2008/133205

(57) **Abstract**

Provided is a silicon crystal material which has dislocation or is polycrystalline, and is manufactured by a CZ method. The silicon crystal material is used as a material rod for FZ single crystal manufacture, does not generate cracks and breakage, and has a section to be grasped for being suspended and held in an FZ furnace. The silicon crystal material to be used for manufacturing silicon single crystal by an FZ method is provided with a silicon seed crystal section, which has dislocation or is polycrystalline and is manufactured by the CZ method; a shoulder section, which is crystal-grown from the seed crystal section and has a gradually increasing diameter; a cylindrical straight body section; and a tail section wherein the diameter gradually reduces. Prior to taking out the material from the furnace after being crystal-grown in the CZ furnace, a cooling step is performed to cool the material to a prescribed temperature for a prescribed time. The residual stress at 300 DEG C or below is 0.6 MPa or less.

## Description

### TECHNICAL FIELD

The present invention relates to a silicon crystal material used as a raw material ingot for manufacturing a ;method) and a manufacturing method of an FZ silicon single crystal using the same. In particular, the present invention relates to a silicon crystal material manufactured by a CZ method used for manufacturing a large diameter FZ silicon single crystal and a manufacturing method of an FZ silicon single crystal using the same.

### BACKGROUND ART

Currently, silicon is typically used as a semiconductor that is widely used industrially as a device for an integrated circuit (IC) and a large-scale integrated circuit (LSI). A silicon single crystal used in the semiconductor industry and the like is manufactured from polycrystalline silicon by a floating zone melting method (floating zone method, FZ method for short) in which a melt zone is formed on a polycrystalline silicon ingot by induction heating, solidified, and a single crystal is grown, or by a pulling method (Czochralski method, CZ method for short) in which the polycrystal is heated and melted in a crucible, a seed crystal is immersed in a melt and pulled therefrom, and a single crystal ingot is grown below the seed crystal.

A manufacturing method is selected from these methods in accordance with usage of the single crystal. In general, a single crystal manufactured by the FZ method is used for high resistivity and a single crystal manufactured by the CZ method is used for low to moderate resistivity.

In recent years, reduction in parasitic capacitance is required in semiconductor devices for mobile communication and in leading-edge C-MOS devices. It is reported that signal loss in transmission and parasitic capacitance in a Schottky barrier diode can be effectively reduced by using a substrate of high resistivity. Given this, a high resistivity silicon wafer manufactured by the floating zone melting method (FZ method) is used for manufacturing a power device such as a high-voltage power device, a thyristor or the like.

Meanwhile, in recent years, a large diameter silicon wafer is sought for improving performance and reducing cost of semiconductor devices. Consequently, a large diameter silicon single crystal of no less than 200 mm in diameter is required, and thus development of a manufacturing method thereof has been awaited.

In a case of manufacturing a large diameter silicon single crystal, particularly of at least 150 mm in diameter, by the FZ method, a polycrystalline silicon material having a diameter of at least 140 mm is considered preferable in usage as a raw material ingot. For example, for manufacturing a silicon single crystal of 200 mm in diameter, a method using polycrystalline silicon having a diameter of at least 145 mm as a silicon raw material ingot is disclosed in Japanese Unexamined Patent Application Publication No. 2003-55089 (hereinafter referred to as Patent Document 1).

As described above, it is generally advantageous to manufacture a silicon single crystal from a silicon raw material ingot with a diameter as large as possible, from a perspective of productivity and the like; however, since a silicon raw material ingot for polycrystalline silicon that is commercially available is manufactured by vapor phase growth, it is difficult to manufacture a large diameter polycrystalline silicon, particularly of at least 150 mm in diameter. In addition, polycrystalline silicon of a large diameter has a drawback of having a nonuniform grain boundary structure. Consequently, a problem of extremely low yield is reported, in a case of manufacturing a silicon single crystal of 200 mm in diameter by the FZ method using a polycrystalline silicon raw material ingot of 160 mm in diameter, since a single manufacturing process by the FZ method cannot make a single crystal dislocation free and therefore the process must be repeated. Furthermore, polycrystalline silicon of a large diameter has another drawback of having a high unit cost.

On the other hand, an attempt is being made to manufacture an FZ silicon single crystal by using a large diameter CZ silicon crystal ingot, manufactured and obtained by the CZ method (for example, see Japanese Unexamined Patent Application Publication No. 2005-281076 and 2005-306653, hereinafter referred to as Patent Documents 2 and 3).

### DISCLOSURE OF THE INVENTION

### Problems to be Solved by the Invention

In a case of crystal growth by the FZ method, a silicon crystal material, which is a raw material silicon rod, is required to be maintained suspended in an FZ furnace. However, a common silicon crystal material manufactured by the CZ method, which is cylindrical, does not have a portion to be gripped. Consequently, the silicon crystal material manufactured by the CZ method must be subjected to mechanical processing for forming a groove and the like after cutting of a shoulder portion and a tail portion of the silicon crystal material, and then loaded into an FZ furnace, being gripped at the groove or the like. In addition, fixing by a screw or the like is required, as disclosed in Patent Documents 2 and 3. As described above, since an operation for forming a groove or the like, for gripping, on the silicon crystal material is required, the manufacturing process not only becomes complex, but material is lost in the operation, and cycle time becomes longer.

The present inventors have focused on the abovementioned problem and proposed a silicon crystal material having a gripping portion formed by temporarily changing a crystal growth condition in a manufacturing process of the silicon crystal material by the CZ method, and also proposed a manufacturing method thereof. In this way, a large diameter silicon crystal material having the gripping portion can be manufactured at relatively low cost; however, a crystal growth condition must be controlled in order to form the gripping portion by changing the crystal growth condition of a CZ silicon single crystal.

Meanwhile, as described above, an FZ silicon single crystal has conventionally been manufactured using a large diameter silicon crystal manufactured by the CZ method; however, dislocated or polycrystalline silicon crystal material manufactured by the CZ method has not been conventionally used as a raw material ingot for manufacturing an FZ silicon single crystal. This is because, in a case where a crystal is rapidly taken off from a CZ furnace at a high temperature about 500°C, a single crystal silicon crystal does not crack or break; however, cracking or breakage easily occurs in the dislocated or polycrystalline silicon crystal material which may break and fall off when used as a raw material ingot for manufacturing an FZ silicon single crystal.

However, it is beneficial if dislocated or polycrystalline silicon crystal material manufactured by the CZ method can be used as a raw material ingot for manufacturing an FZ silicon single crystal, since the abovementioned control of a crystal growth condition is not required.

The present invention is made in view of the abovementioned problems, and aims at providing dislocated or polycrystalline silicon that is manufactured by the CZ method as a silicon crystal material that can be used for manufacturing a silicon single crystal by the FZ method.

### Means for Solving the Problems

The present inventors have thoroughly researched in order to solve the abovementioned problems and found that, even with dislocated or polycrystalline silicon manufactured by the CZ method, a silicon crystal material with high mechanical strength, which can be used as a raw material ingot for manufacturing a silicon single crystal by the FZ method, can be obtained by devising a CZ manufacturing process, thus leading to the completion of the present invention.

More specifically, the present invention provides the following.

In a first aspect of the present invention, a silicon crystal material used for manufacturing a silicon single crystal by an FZ method is **characterized in that** the silicon crystal material is dislocated or polycrystalline silicon, manufactured by the CZ method.

According to the first aspect of the present invention, dislocated or polycrystalline silicon manufactured by the CZ method can be used as a raw material ingot for manufacturing a silicon single crystal by the FZ method. Since a large diameter raw material ingot can be manufactured by the CZ method, a large diameter FZ silicon single crystal can be manufactured. In addition, control of a crystal growth condition is not required, as in a method of forming a gripping portion by changing the crystal growth condition of a CZ silicon single crystal. Therefore, a large diameter FZ silicon single crystal can be easily manufactured at low cost.

According to a second aspect of the present invention, in the silicon crystal material as described in the first aspect, residual stress of the dislocated or polycrystalline silicon at 300°C is no greater than 0.6 MPa.

According to the second aspect, since residual stress of the dislocated or polycrystalline silicon at 300°C is no greater than 0.6 MPa, which is lower than breaking strength of polycrystalline silicon, 0.75 MPa/m², the dislocated or polycrystalline silicon has high mechanical strength required for use as a raw material ingot for an FZ silicon single crystal. Consequently, even in a case where the silicon crystal material is used as a raw material ingot for an FZ silicon single crystal, falling off due to cracking and breakage in the silicon crystal material will not occur, in a process of heating and melting the silicon crystal material and growing an FZ silicon single crystal.

According to a third aspect of the present invention, in the silicon crystal material according to the first or the second aspect, the dislocated or polycrystalline silicon includes: a seed crystal portion; a shoulder portion that gradually grows in diameter, formed by crystal growth from the seed crystal portion; a straight body portion that is cylindrical; and a tail portion that gradually reduces in diameter.

According to the third aspect, the silicon crystal material which is grown directly from a seed crystal portion used in the CZ method and integrated with a straight body portion can be used as a raw material ingot for an FZ silicon single crystal. In other words, since the silicon crystal material is the dislocated or polycrystalline silicon, a dash-necking process (a process of narrowing down a seed crystal) that is normally performed in a CZ single crystal manufacturing process is not required, and a straight body portion can be formed by growing a crystal from the seed crystal portion directly. Consequently, since mechanical strength of an area between the straight body portion and the seed crystal portion is high, the silicon crystal material can be maintained suspended in an FZ furnace without breaking even when gripped at the seed crystal portion and used as a raw material ingot for an FZ silicon single crystal.

According to a fourth aspect of the present invention, in the silicon crystal material as described in any one of the first to the third aspect, the dislocated or polycrystalline silicon is manufactured through a slow cooling step in which the dislocated or polycrystalline silicon is slowly cooled to a predetermined temperature over a predetermined period of time, after crystal growth thereof in a CZ furnace and before removal thereof from the furnace.

According to the fourth aspect, since the silicon crystal material is manufactured through a slow cooling step in which the silicon crystal material is slowly cooled to a predetermined temperature over a predetermined period of time after crystal growth thereof in a CZ furnace and before removal thereof from the furnace, residual stress immanent therein is reduced and thus a crack and breakage is suppressed. Therefore, in a case where the silicon crystal material is used as a raw material ingot for manufacturing an FZ silicon single crystal, the silicon crystal material will not generate a crack and breakage and drop off.

A method of the slow cooling is not particularly limited and can be any method reducing the residual stress in the silicon crystal material to such a degree that a crack and breakage do not occur in manufacturing of a silicon single crystal by the FZ method. For example, a method of performing at least once a step of pulling a crystal at a predetermined rate to a predetermined height and holding for a predetermined period of time, after finishing crystal growth by the CZ method and separation from a melt, can be adopted. In addition, temperature of the silicon crystal material is preferably cooled down to about 300°C by the slow cooling.

According to a fifth aspect of the present invention, in the silicon crystal material as described in the fourth aspect, the slow cooling step includes at least once performing a step of pulling the dislocated or polycrystalline silicon at a predetermined rate to a predetermined height and holding for a predetermined period of time.

According to the fifth aspect, since the dislocated or polycrystalline silicon is held for a predetermined period of time under an atmosphere of lower temperature than a melt surface by pulling at a predetermined rate to a predetermined height and holding for a predetermined period of time, the silicon crystal material grown in a CZ furnace is gradually cooled. Consequently, the residual stress immanent in the silicon crystal material is sufficiently reduced and high mechanical strength can be obtained that is enough for use as a raw material ingot for manufacturing an FZ silicon single crystal.

In a sixth aspect of the present invention, a manufacturing method of an FZ silicon single crystal is **characterized in that** an FZ silicon single crystal is manufactured using the silicon crystal material as described in any one of the first to the fifth aspects.

According to the sixth aspect of the present invention, since the silicon crystal material as described in any one of the first to the fifth aspects is used as a raw material ingot for manufacturing an FZ silicon single crystal, a large diameter FZ silicon single crystal can be easily manufactured at low cost. Particularly, by using a CZ silicon crystal material that is grown directly from the seed crystal portion without a dash-necking process, or a CZ silicon crystal material of which residual stress is adjusted to be no greater than a predetermined value by performing a predetermined slow cooling step and the like as a raw material ingot for manufacturing an FZ silicon single crystal, high mechanical strength can be obtained and therefore the silicon crystal material can be maintained suspended in an FZ furnace without breaking.

### Effects of the Invention

According to the present invention, dislocated or polycrystalline silicon that is manufactured by the CZ method can be provided as a silicon crystal material that can be used for manufacturing a silicon single crystal by the FZ method. More particularly, by using a CZ silicon crystal material of which residual stress is alleviated by performing a predetermined slow cooling step and the like as a raw material ingot for manufacturing an FZ silicon single crystal, the silicon crystal material can be maintained suspended in an FZ furnace without breaking. Furthermore, by using a CZ silicon crystal material that is grown directly from the seed crystal portion without a dash-necking process, as a raw material ingot for manufacturing an FZ silicon single crystal, the silicon crystal material can be maintained suspended in an FZ furnace without breaking, even when gripped at the seed crystal portion and used as a raw material ingot for an FZ silicon single crystal.

### BRIEF DESCRIPTION OF THE DRAWINGS

FIG. 1 is a schematic vertical sectional view of a silicon crystal material according to the present invention;
FIG. 2 is a schematic diagram of a CZ silicon crystal material manufacturing device used for manufacturing the silicon crystal material according to the present invention;
FIG. 3A to 3D are diagrams illustrating manufacturing steps of a silicon crystal material according to the present invention;
FIG. 4 is a partial sectional view schematically illustrating an example of an FZ single crystal manufacturing device according to the present invention; and
FIG. 5 is a partial sectional view schematically illustrating a state where the silicon crystal material according to the present invention is gripped.

### PREFERRED MODE FOR CARRYING OUT THE INVENTION

A silicon crystal material according to the present embodiment is described in detail hereinafter.

The silicon crystal material according to the present embodiment is dislocated or polycrystalline CZ silicon crystal material and includes: a seed crystal portion; a shoulder portion that gradually grows in diameter, grown from the seed crystal portion; a straight body portion that is cylindrical; and a tail portion that gradually reduces in diameter, and has high mechanical strength.

In addition, the silicon crystal material according to the present embodiment is manufactured through a step of slowly cooling a crystal after crystal growth to a predetermined temperature, in a process of manufacturing a large-diameter dislocated or polycrystalline silicon crystal material by the CZ method, which is used as a raw material ingot for manufacturing an FZ silicon single crystal. Furthermore, the silicon crystal material according to the present embodiment is manufactured by growing a CZ silicon crystal material without performing a dash-necking process.

The silicon crystal material according to the present embodiment is described hereinafter with reference to the drawings. It should be noted that the present invention and the technical scope of the invention are not limited to the following embodiments. In the following description of the embodiments, similar components are designated by the same reference numerals, with the description thereof simplified or omitted.

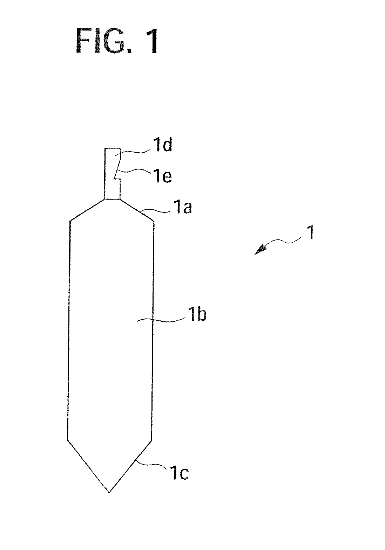

FIG. 1 is a schematic vertical sectional view of a silicon crystal material 1 according to the present embodiment. The silicon crystal material 1 is a dislocated or polycrystalline silicon crystal composed of: a seed crystal portion 1d having a bored portion 1e; a shoulder portion 1a that is continuous with the seed crystal portion 1d; a straight body portion 1b of a main body portion; and a tail portion 1c. Consequently, the silicon crystal material 1 can be maintained suspended in an FZ furnace by gripping the seed crystal portion 1d when used as a raw material ingot for an FZ silicon single crystal.

As described below, the silicon crystal material 1 is manufactured by the CZ method, in which a silicon crystal is grown from the seed crystal portion 1d and, after crystal growth thereof, goes through a slow cooling step in which the silicon crystal is slowly cooled to a predetermined temperature over a predetermined period of time, and then is removed from a furnace, without performing a dash-necking process. This reduces residual stress in the silicon crystal material 1, therefore in a case where the silicon crystal material 1 is used as a raw material ingot for manufacturing a silicon single crystal by the FZ method, the silicon crystal material 1 will not drop off by the occurrence of cracking or breakage.

### Manufacturing Method of Dislocated or Polycrystalline Silicon Crystal Material

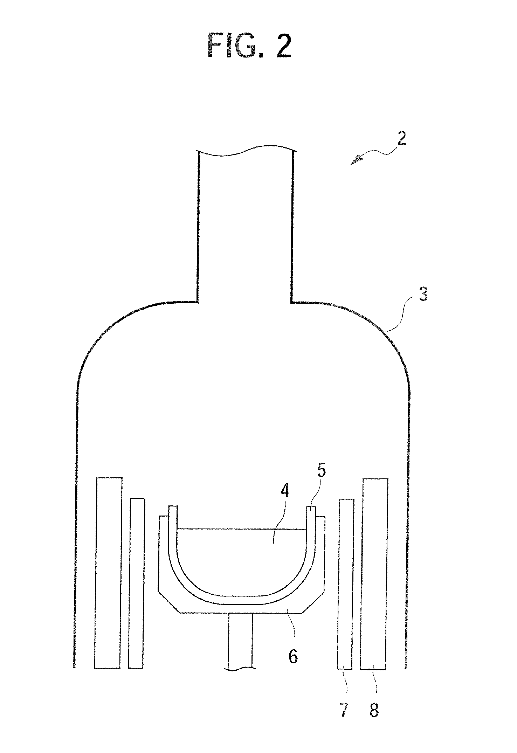

A manufacturing method of dislocated or polycrystalline silicon crystal material 1 according to the present embodiment is described hereinafter. FIG. 2 is a partial schematic view of a CZ silicon crystal material manufacturing device for manufacturing the silicon crystal material 1 according to the present embodiment. In a CZ furnace 3 of the CZ silicon crystal material manufacturing device 2, a quartz crucible 5 for retaining polycrystalline silicon melt 4, which is a raw material for the silicon crystal material 1 that is to be pulled, and a graphite crucible 6 for housing the quartz crucible 5 are disposed to be capable of rotation and of moving up and down. An annular shaped heater 7 and a graphite heat insulation material 8 are disposed around the graphite crucible 6. It should be noted that the silicon crystal material manufacturing device 2 is merely an example and the present invention is not limited thereto.

Next, a pulling step of the silicon crystal material 1 using the silicon crystal material manufacturing device 2 is explained. In the pulling step of the silicon crystal material 1, a dash-necking process that is normally performed is not performed, and a step of slowly cooling the silicon crystal material 1 pulled from the melt 4 is added after separating the silicon crystal material 1 from the melt 4 and before removal from the CZ furnace 3. The process is described in detail hereinafter.

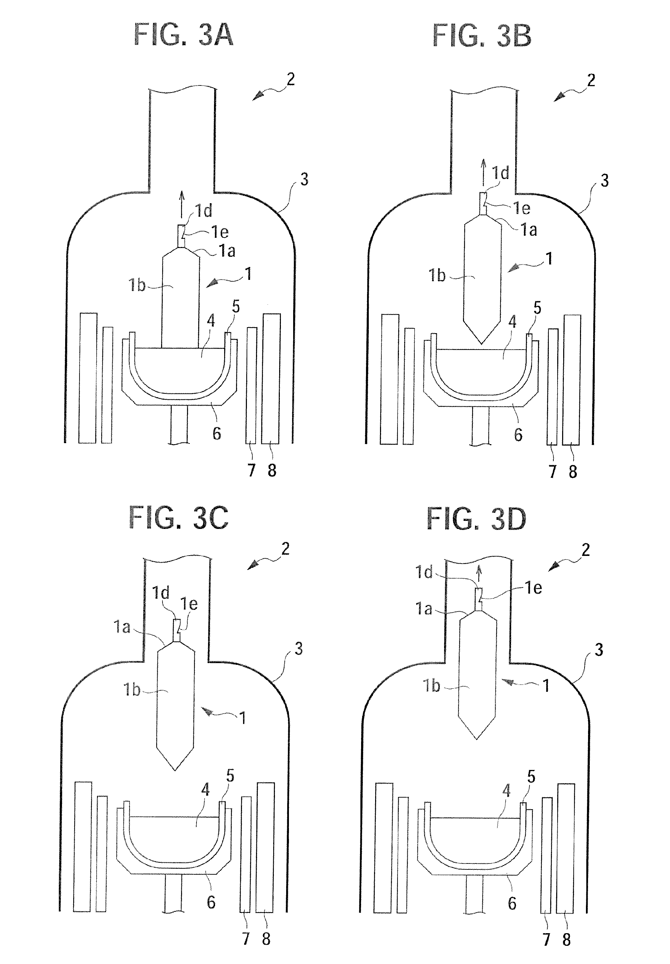

FIGS. 3A to 3D are explanatory drawings illustrating manufacturing steps of the silicon crystal material 1. 3A is a diagram illustrating a state of growing the silicon crystal material 1 while pulling a seed crystal from the melt 4; 3B is a diagram illustrating a state where the silicon crystal material 1 is separated from the melt 4 after growth thereof; 3C is a diagram illustrating a state where the silicon crystal material 1 is stopped and held at a predetermined position; and 3D is a diagram illustrating a state of pulling the silicon crystal material 1 again at low rate.

First, the heater 7 is turned on in order to set a temperature profile of the crucibles 5 and 6 to a desired state, thereby melting a material, which is an agglomerate of polycrystalline silicon. Next, Ar gas is supplied from an upper portion of the CZ furnace 3 and discharged from a lower portion of the CZ furnace 3, at a furnace pressure of 1333 Pa and a feed rate of Ar gas of 50 1/min, for example.

Thereafter, the seed crystal portion 1d is immersed in the melt 4 in which polycrystalline silicon is melted, and pulled at a predetermined pulling rate (normally 0.1 to 1 mm/min), thereby growing the shoulder portion 1a. Thereafter, by pulling at a rate of 0.5 to 1.5 mm/min as shown in FIG. 3A, the straight body portion 1b of a predetermined length is grown while maintaining a predetermined diameter. In other words, in silicon single crystal manufacturing by the CZ method, the straight body portion 1b of the silicon crystal material 1 is grown directly from the seed crystal portion 1d, without performing a dash-necking process that is normally practiced. The dislocated or polycrystalline silicon crystal material 1 is thus grown.

After growing the straight body portion 1b to a predetermined length, crystal diameter thereof is gradually decreased in order to avoid rapid increase in thermal strain, and the silicon crystal material 1 is separated from the melt 4 while forming the tail portion 1c, as shown in FIG. 3B.

The silicon crystal material 1 pulled from the melt 4 is pulled until a lower end thereof reaches a height of 100 to 200 m from a surface of the melt 4 at a pulling rate adopted in the conventional CZ method (normally 0.1 to 1 mm/min). In addition, the heater 7 is powered down and temperature of the melt 4 is lowered.

At this height, pulling is stopped and the silicon crystal material 1 is held for 60 to 100 minutes as shown in FIG. 3C. The silicon crystal material 1 that is pulled is thus cooled down to a predetermined temperature. Thereafter, the silicon crystal material 1 is pulled again at a predetermined low rate as shown in FIG. 3D, thereby finishing growth of the silicon crystal material 1. It should be noted that the abovementioned step of stopping and holding can be performed in several times. The silicon crystal material 1 that is pulled from the melt 4 is thus slowly cooled in the CZ furnace 3. It should be noted that conditions such as the height for stopping and holding, and holding time, is accordingly set in accordance with a structure and a hot zone of the CZ furnace so that residual stress at 300°C is no greater than 0.6 MPa.

Thereafter, the CZ furnace 3 is opened and the silicon crystal material 1 that is manufactured is removed therefrom so as not to break the seed crystal portion 1d, and cooled down to ambient temperature.

As a result, the silicon crystal material 1 can be maintained suspended in an FZ furnace when used as a raw material ingot for an FZ silicon single crystal, since the seed crystal portion 1d is not broken even when gripped. In addition, residual stress within the silicon crystal material 1 is lowered to no greater than 0.6 MPa.

Diameter of the seed crystal portion 1d used for pulling is not particularly limited, and is preferably no less than 15 mm. This is because the seed crystal portion 1d may break with thickness less than 15 mm, since the seed crystal portion 1d as a gripping portion is gripped in a case where the silicon crystal material 1 thus manufactured is maintained suspended in the FZ furnace as a raw material ingot for manufacturing an FZ silicon single crystal. In addition, a bored portion 1e is preferably formed thereon, but is not essential.

### Manufacturing Method of FZ Silicon Single Crystal

Next, a manufacturing method of an FZ silicon single crystal using the silicon crystal material 1 according to the present embodiment is explained.

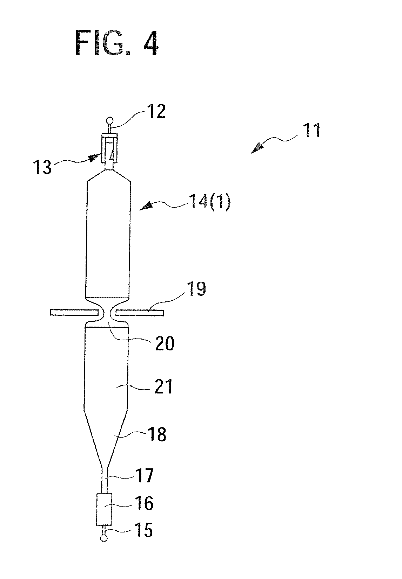

FIG. 4 is a schematic partial sectional view illustrating an example of an FZ silicon single crystal manufacturing device 11 according to the present embodiment. An FZ silicon single crystal manufacturing device 11 has a structure similar to a conventional FZ silicon single crystal manufacturing device, and includes: a gripper 13 that grips a raw material ingot (the silicon crystal material) 14 and an upper spindle 12 that is continuous with the gripper 13 on an upper portion thereof; a crystal gripper 16 that grips a seed crystal 17 for an FZ silicon single crystal and a lower spindle 15 that is continuous with the crystal gripper 17 on a lower portion thereof; and an induction heating coil (a high-frequency coil) 19 therebetween. The upper spindle 12 and the lower spindle 15 are possible to rotate and to move up and down.

The abovementioned silicon crystal material 1 manufactured by the CZ method is, as shown in FIG. 4, gripped by the gripper 13 on the upper spindle 12 of the FZ silicon single crystal manufacturing device 11 that is installed in a chamber (not shown) of an FZ growth furnace, and set as a silicon raw material ingot 14. A seed crystal 17 for manufacturing an FZ silicon single crystal is set on the lower crystal gripper 16 on the lower spindle 15.

More specifically, the silicon crystal material 1 is set on the single crystal manufacturing device 11 as follows.

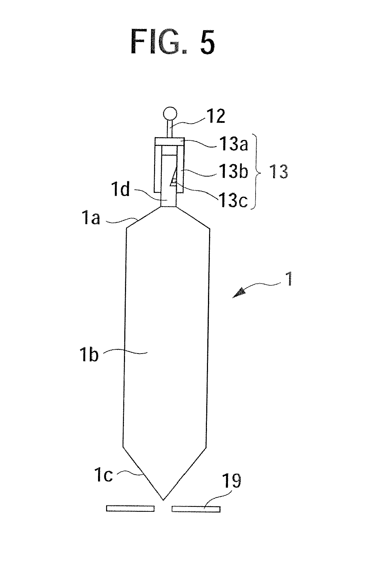

The silicon crystal material 1 is gripped at the seed crystal portion 1d by the gripper rod 13b of the gripper 13 as shown in FIG. 5. In this case, the gripper 13 is not particularly limited as long as a mechanism is provided for gripping the seed crystal portion 1d; and the gripper 13, for example, can be composed of: a plate-like supportive portion 13a; a plurality (preferably at least 3 for supporting a weighty silicon crystal material from a perspective of stability) of gripper rods 13b that is rotationally attached to the supportive portion 13a. In addition, a pin 13c, which can be taken in and out toward the silicon crystal material side, is preferably formed on a lateral face of the gripper rod 13b facing the seed crystal portion 1d. In such a configuration, the pin 13c of the gripper rod 13b is inserted into the bored portion 1e (see FIG. 1) formed on the seed crystal portion 1d, thereby maintaining the silicon crystal material 1 suspended more firmly. It should be noted that FIG. 5 is a partial sectional view schematically illustrating a state where the silicon crystal material 1 according to the present invention is gripped.

Subsequently, a lower end of the tail portion 1c of the silicon raw material ingot 14 is preheated by a carbon ring (not shown). Thereafter, Ar gas containing nitrogen gas is supplied from a lower portion of the chamber and discharged from an upper portion of the chamber, so that a furnace pressure is 0.20 MPa, a feed rate is Ar gas of 20 L/min, and nitrogen concentration inside the chamber is 0.5%. Next, after heating and melting the silicon raw material ingot 14 by the induction heating coil (the high-frequency coil) 19, an apex of the tail portion 1c is fused with the seed crystal 17 and made dislocation-free by necking, the silicon raw material ingot 14 is brought down and melted while rotating the upper spindle 12 and the lower spindle 15 for supplying a melt to a melt zone 20. The FZ silicon single crystal 21 is grown at a rate of 1.0 to 3.0 mm/min from a lower portion of the melt zone 20. In this case, the upper spindle 12 that is a rotational center when the silicon raw material ingot 14 is growing and the lower spindle 15 that is a rotational center of the silicon single crystal 21 in recrystallization are coaxial and rotate around a common rotational center. In addition, the axes preferably rotate back and forth alternately and grow the single crystal. By rotating back and forth alternately, a molten state is agitated in recrystallization, and thus quality, such as radial resistivity distribution of the silicon single crystal 21 thus manufactured can be uniformized. A moving angle of backward and forward rotation, rotation rate and the like can be arbitrarily set in accordance with a diameter of the silicon single crystal.

In such a configuration, a dopant that is contained in the silicon raw material ingot (silicon crystal material) 14 manufactured by the CZ method can be uniformly distributed in the melt zone 20 and thus the dopant can also be uniformly distributed in the FZ silicon single crystal 21, thereby obtaining a silicon single crystal with a superior radial resistivity distribution in crystal.

Alternatively, the dopant can be gas-doped while recrystallization. In this case, by selecting a doping gas type and adjusting doping rate, a conductivity type of the silicon single crystal can be made the same as or opposite to that of the raw material ingot, and resistivity thereof can be arbitrarily adjusted.

### EXAMPLES

Examples of the present invention are described in detail hereinafter; however, the present invention is not limited thereto.

### Example 1

A silicon crystal material with a straight body portion of 1000 mm in length and 150 mm in diameter, which is to be used as a raw material ingot for an FZ silicon single crystal, was pulled using a seed crystal of 20 mm in diameter without performing a dash-necking process that is normally performed in the CZ method. Here, a dopant (impurity) such as boron, phosphorus, arsenic, antimony and the like, was not added thereto. A silicon crystal in which the seed crystal portion 1d was continuous and integrated with the shoulder portion 1a of the silicon crystal material 1 was grown.

After crystal growth in the CZ furnace, the silicon crystal material was separated from a melt surface, pulled to a height of 135 mm at a rate of 625 mm/min, held at the height and left for 76 minutes. Meanwhile, a heater was powered down to solidify the melt remaining in the crucible. A maximum temperature of the silicon crystal material was thus lowered from 1400°C to 934°C.

Next, the silicon crystal material was pulled again to a height of 854 mm at a rate of 625 mm/min, held at the height and left for 120 minutes. A maximum temperature of the silicon crystal material was thus lowered from 934°C to 747°C.

Thereafter, the silicon crystal was pulled at a rate of 0.01 mm/min for 160 minutes. A maximum temperature of the silicon crystal material was thus lowered from 747°C to 357°C.

Furthermore, the silicon crystal was pulled at a rate of 1.0 mm/min for 20 minutes. A maximum temperature of the silicon crystal material was thus lowered from 357°C to 304°C. For reference, a stress value calculated at this final step by simulation was 0.55 MPa.

After cooling down to the abovementioned temperature, the furnace was opened and the silicon crystal material was taken out therefrom and cooled down to ambient temperature outside the furnace. It should be noted that the silicon crystal material is taken out from the CZ furnace without breaking the seed crystal portion.

Dislocated or polycrystalline silicon crystal material having a straight body portion of 155 mm in diameter and 1000 mm in length, in which the seed crystal was continuous and integrated with a crystal main body (the straight body portion), was thus manufactured.

The silicon crystal material thus obtained was, after a surface thereof was cleaned with mixed acid, loaded into an FZ furnace by gripping the seed crystal portion of the silicon crystal material with a gripper that houses the seed crystal inside thereof and inserts a pin into a bored portion on the seed crystal portion. It should be noted that, in loading, a centering operation for rotation of the silicon crystal material inside the FZ furnace was not required since the seed crystal and a main crystal body (the straight body portion) had a common rotational center.

Thereafter, a silicon single crystal was grown by a commonly practiced FZ method, thereby manufacturing an FZ silicon single crystal having a straight body portion of 150 mm in diameter and 1000 mm in length. It should be noted that an n-type single crystal was obtained by spraying phosphine by gas doping while the silicon single crystal was being pulled. Comparative Example 1

A silicon crystal material having a straight body portion of 155 mm in diameter and 1000 mm in length was manufactured according to a commonly practiced CZ method.

Next, a shoulder portion or a tail portion of the silicon crystal material thus obtained was cut off and a groove of 5 mm in depth and 5 mm in width was formed on a peripheral surface of the vicinity of the portion being cut off, by a mechanical process.

Next, the silicon crystal material was loaded into an FZ furnace by fixing the groove with a gripper. Centering was performed for rotating the silicon crystal material, utilizing the groove thereof.

Thereafter, an FZ silicon single crystal was grown by the FZ method under the same condition as in Example 1, thereby manufacturing an FZ silicon single crystal having a straight body portion of 150 mm in diameter and 1000 mm in length. Comparative Example 2

On a commercially available polycrystalline material having a straight body portion of 155 mm in diameter and 1000 mm in length, as a raw material ingot for an FZ silicon single crystal, a groove was formed by a mechanical process as in Comparative Example 1. The polycrystalline material was then loaded into an FZ furnace by fixing the groove with a gripper as in Comparative Example 1. Centering was performed for rotating the silicon crystal material. Thereafter, an FZ silicon single crystal having a straight body portion of 150 mm in diameter and 1000 mm in length was manufactured under the same condition as in Example 1.

Resistivity distribution in crystal, oxygen concentration, and crystal defect distribution were evaluated for each of the FZ silicon single crystals obtained in Example 1 and Comparative Example 1. Results are shown in Table 1.

**Table 1**

| | Resistivity Distribution | Oxygen Concentration | Crystal Defect |
|---|---|---|---|
| Example 1 | 100 Ω cm ± 8.2 % | No greater than 0.2 ppm | Undetected |
| Comparative Example 1 | 100 Ω cm ± 7.9 % | No greater than 0.2 ppm | Undetected |
| Comparative Example 2 | 100 Ω cm ± 8.0 % | No greater than 0.2 ppm | Undetected |

From the results shown in Table 1, the FZ silicon single crystal of Example 1 was confirmed to have a similar crystal quality as the FZ silicon single crystals of Comparative Examples 1 and 2.

## Claims

1. Silicon crystal material used for manufacturing a silicon single crystal by an FZ method, **characterized in that**
the silicon crystal material is dislocated or polycrystalline silicon, manufactured by a CZ method.

2. The silicon crystal material according to claim 1, wherein residual stress of the dislocated or polycrystalline silicon at 300°C is no greater than 0.6 MPa.

3. The silicon crystal material according to claim 1 or 2, wherein the dislocated or polycrystalline silicon includes: a seed crystal portion; a shoulder portion that gradually grows in diameter, formed by crystal growth from the seed crystal portion; a straight body portion that is cylindrical; and a tail portion that gradually reduces in diameter.

4. The silicon crystal material according to any one of claims 1 to 3, wherein the dislocated or polycrystalline silicon is manufactured through a slow cooling step in which the dislocated or polycrystalline silicon is slowly cooled to a predetermined temperature over a predetermined period of time, after crystal growth thereof in a CZ furnace and before removal thereof from the CZ furnace.

5. The silicon crystal material according to claim 4, wherein the slow cooling step includes at least once performing a step of pulling the dislocated or polycrystalline silicon at a predetermined rate to a predetermined height and holding for a predetermined period of time.

6. A manufacturing method of an FZ silicon single crystal, **characterized in that** an FZ silicon single crystal is manufactured using the silicon crystal material according to any one of claims 1 to 5.
